## Europäisches Patentamt
## European Patent Office
## Office européen des brevets

(19)

(11) Publication number: **0 041 292**
**A1**

(12)

# EUROPEAN PATENT APPLICATION

(21) Application number: **81200542.9**

(22) Date of filing: **21.05.81**

(51) Int. Cl.³: **G 03 C 5/00**
**G 03 G 13/26, B 41 C 1/10**

(30) Priority: **29.05.80 NL 8003132**

(43) Date of publication of application:
**09.12.81 Bulletin 81/49**

(84) Designated Contracting States:
**AT BE CH DE FR GB IT LI LU NL SE**

(71) Applicant: **VECO BEHEER B.V.**
**22, K. van Gelreweg**
**NL-6960 AA Eerbeek(NL)**

(72) Inventor: **Mohan, Anand**
**4 't Spiker**
**NL-7231 JS Warnsveld(NL)**

(72) Inventor: **Barendregt, Frank**
**1 Corn. Ketelstraat**
**NL-5831 TZ Boxmeer(NL)**

(74) Representative: **van der Veken, Johannes**
**Adriaan et al,**
**EXTERPATENT 3 & 4 Willem Witsenplein**
**NL-2596 BK The Hague(NL)**

(54) **Process of forming metal products.**

(57) A process of forming metal articles by providing a metal substrate 1 with fixed photo lacquer coating regions 2a-2d the surface of which regions 2a-2d is given a polarity by means of a corona discharge, whereupon the surfaces of the charged regions 2a-2d are coated with loose plastics particles by using a toner. Subsequently these loose plastics particles are transferred to a metal carrier 5, whereafter the plastics particles are fused together. Thereafter the uncoated parts of the carrier 5 are removed by etching, thus forming apertures 6 or a metal 7a-7c, which is deposited in a galvanic way and lastly the plastics layers 4a-4d are removed.

An installation for forming these metal articles comprises a support 8 for moving metal substrates 1, a charging element 11 for a corona discharge, a plastics applying member 14, a second support 16 for moving a carrier 5, and positioning same opposite a substrate, an electrode 17 for charging the carrier, a device 18 for fusing the plastics particles of regions 4a-4d, an etching device 19 or metal depositing device 20 for depositing a metal in the spaces between regions 4a-4d, and a plastics removing bath 9 for removing plastics regions 4a-4d.

EP 0 041 292 A1

_Fig: 7_

-1-

## Process of forming metal articles

The invention relates to a process of forming metal articles by applying a plastics pattern upon a metal carrier, whether or not followed by a metal removal or chemical deposition or chemical treatment, known per se and a removal of the plastics.

It is known in the art to obtain various, eventually perforated, foil-like metal articles by providing the metal foil or sheet with a photo lacquer coating, exposing said photo lacquer coating through a dia-positive or a dia-negative, and subsequently developing same; the plastics may be fused thereto, whereupon undesired portions of the carrier are removed by etching or certain metals are deposited upon the carrier by a galvanic deposition.

This process presents the disadvantage that for each metal article a carrier has to be coated with the photo lacquer coating, whereupon said coating has to be dried and subsequently exposed through a dia-positive or a dia-negative, dependent upon the kind of coating as used, which separate steps are rather time-consuming.

-2-

Especially when metal articles of the same type have to be produced in large series, it is preferred to carry out a process in which a number of the abovedescribed steps could be eliminated.

According to the invention this object is attained in that a removable plastics pattern coating is applied upon a charged, fixed primary plastics pattern located upon a conducting substrate, said removable plastics being subsequently transferred to an electrically conducting carrier, by providing a potential difference between the substrate and the carrier, thereby forming a secondary plastics pattern upon the carrier, whereupon, after having fixed said plastics pattern, if desired, either metal is removed from the carrier by etching, or metal is deposited upon said carrier and subsequent to said etching or metal deposition treatment, the secondary plastics pattern is removed.

By means of said process carriers can be obtained comprising a desired plastics pattern without the necessity of first coating said carrier with a photo lacquer coating, drying said photo lacquer coating and exposing each carrier separately.

The removable plastics coating will, as a matter of fact, directly form the desired pattern upon the carrier, which pattern, after having been fixed, may either serve for a protection of portions of the carrier not to be removed by etching, or for protecting portions of the carrier upon which no metals should be deposited.

Due to etching away non-coated portions of the carrier, metal products are obtained which may be used for integrated circuits, while small quantities of, e.g., very precious metals, such as gold or silver, may be optimally deposited on predetermined locations without any disadvantageous result in the clarity of the pattern, obtained either by a galvanic deposition or by etching.

The removable plastics coating is very conveniently applied upon the fixed primary plastics pattern by charging said primary plastics pattern with a charge possessing a certain polarity, more particularly by means of a corona discharge.

The removable plastics coating is advantageously applied by depositing plastics particles from a dispersion in a non-electrically conducting liquid, more particularly an isoparaffin.

The present invention also relates to an installation for carrying out the process according to the invention.

Said installation for applying a plastics pattern coating upon the surface of the metal carrier and for fixing said plastics coating, whether or not followed by a chemical or galvanic treatment known per se, comprising at least a support for the carrier, a member for applying plastics and a member for fixing applied plastics, is characterized in that the installation at least comprises a charging member for charging a plastics material, a plastics particlesapplying member and a member for providing the carrier with a potential.

The present invention will be illustrated by means of an

-4-

example of an embodiment in the accompanying drawings, wherein:

Fig. 1 shows a substrate comprising a fixed primary plastics pattern;

Fig. 2 shows the fixed primary plastics pattern provided with a removable plastics coating;

Fig. 3 shows the situation in which the carrier is located above the fixed primary plastics pattern, being provided with the removable plastics coating;

Fig. 4 shows the carrier with the plastics pattern transferred thereupon;

Fig. 5 shows the carrier as obtained in fig. 4, after an etching procedure;

Fig. 5A shows the carrier of fig. 5 after having removed the plastics;

Fig. 6 shows the carrier of Fig. 4 after having deposited a metal coating;

Fig. 6A shows the carrier of Fig. 6 after having removed the plastics;

Fig. 7 schematically shows an installation for executing the process in accordance with the present invention.

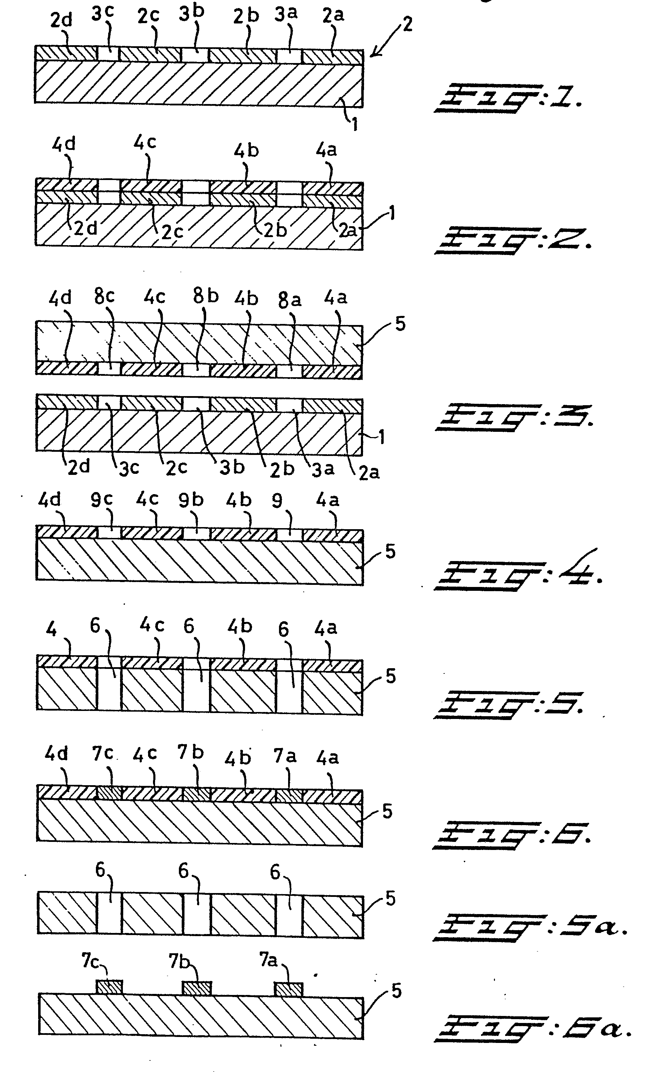

Fig. 1 shows a substrate in the form of a nickel sheet 1, upon which, by coating with a photo lacquer coating 2, a fixed primary plastics pattern has been formed, thereby maintaining predetermined primary fixed plastics pattern regions 2a, 2b, 2c and 2d and forming cavities 3a, 3b and 3c.

A corona discharge will provide the plastics surface of the regions 2a, 2b, 2c and 2d with a certain polarity. After said corona discharge, the charged surface of the fixed primary

-5-

plastics regions is coated with a coating 4, consisting of removable plastics particles, such as epoxy resin particles, by applying a dispersion of plastics particles in an isoparaffin, a so-called toner. Said plastics particles possess a polarity being opposite to the polarity of the surface of the regions 2a, 2b, 2c and 2d.

After having deposited removable regions 4a, 4b, 4c and 4d of plastics coating, a metal carrier 5 is positioned above the surface of said regions 4a to 4d incl.; mostly a nickel sheet, although other metals can also be used.

By applying a potential difference between the carrier 5 and the regions 4a to 4d incl. the plastics particles in said regions 4a to 4d incl. are transferred to the carrier 5, while forming regions 4a to 4d incl., constituting the pattern upon the carrier 5.

Subsequently, the plastics regions 4a to 4d incl. upon the carrier 5 are fixed by heating. The uncoated portions of the carrier 5 may then be etched in the metal etching member 19 by means of an acid, so that portions of the carrier which are not covered by plastics coatings 4a to 4d incl. are etched away and continuous apertures 6 are formed at said locations.

After having fixed the plastics regions 4a to 4d incl. upon the carrier 5, said carrier comprising the regions 4a to 4d incl. may also be subjected to a galvanic treatment by a member 20 for galvanically depositing metals in non-covered regions. The metals used for that aim are advantageously precious metals, such as gold and silver. It will be obvious that metals of a different type can also be used. In that case metal deposits 7a, 7b and 7c are obtained in the cavities 8a, 8b and 8c.

Fig. 7 finally shows an installation for executing the process in accordance with the present invention.

The installation of fig. 7 comprises an endless belt 8 for supporting and conveying the substrate 1 being provided with a photo lacquer pattern according to fig. 1.

A corona discharger 11 in a first station provides the surface of the photo lacquer coated regions 2a to 2 d incl. with an electrostatic charge, whereas the substrate 1 is connected with the earth potential.

Subsequently the substrate 1 with the charged regions 2a, 2b 2c and 2d of the photo lacquer coating 2 is brought below an auxiliary electrode 12, which electrode, by means of a potential providing device 21, is provided with a potential having the same polarity as the charge of the photo lacquer coated regions 2a to 2d incl., although the formed polarity is slightly lower in an absolute value.

The auxiliary electrode or developing electrode 12, is located at a short distance of, for instance, 0,5 mm, above the surface of the electrostatically charged photo lacquer coated regions 2a to 2 d incl.

Liquid toner from a storage vessel 14 is supplied via line 13, which extends into a mouth 15 being located between the deve-

-7-

loping electrode 12 and the free surface of the charged photo lacquer coated regions 2a to 2d included.

The plastics particles as applied preferably possess dielectric and very good film forming properties.

The use of the developing electrode 12 allows to prevent a deposit of plastics particles upon uncoated portions of the substrate, but exclusively upon the surface of the electrostatically charged photo lacquer coated regions 2a to 2d incl. Plastics particles coatings 4a to 4d are then formed upon these regions.

Subsequently the pretreated substrate, comprising photo lacquer coated regions and loose plastics particles in the regions 2a to 2d included, is positioned beneath a carrier 5, in the form of a thin nickel sheet, having a thickness of e.g. 200 micrometer; by means of a potential providing device 17 the carrier 5 is given a potential having a polarity corresponding to and being in absolute value somewhat higher than, the potential of the photo lacquer coated regions 2a to 2d included, upon which plastics particles have been deposited.

Now loose plastics particles in the regions 4a to 4d incl. are transferred upon the surface of the carrier 5. Said carrier 5 is conveyed by an endless belt 16.

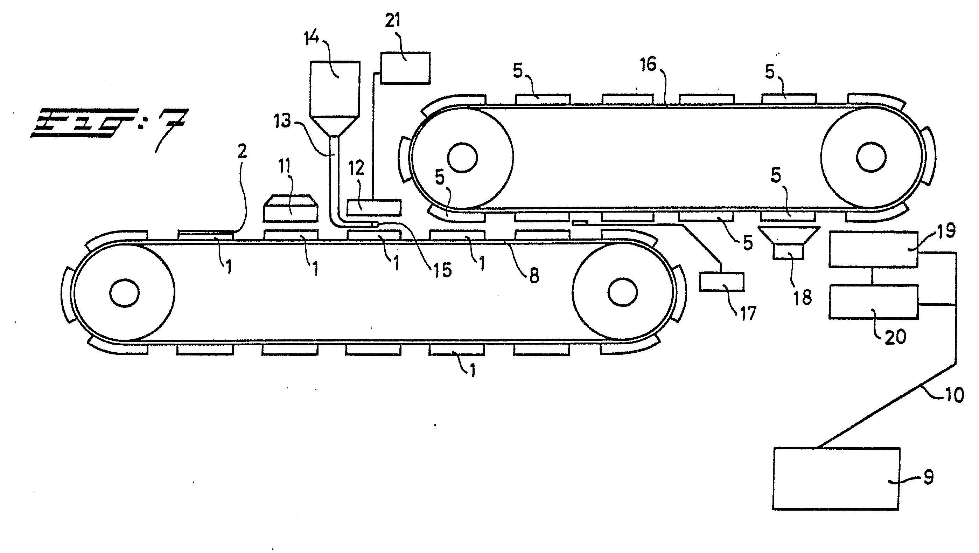

After having transferred the plastics particles regions 4a to 4d incl. upon the carrier 5, a carrier is obtained as shown in the uppermost part of fig. 3. By means of a heating

-8-

device 18 the plastics particles are fused to the surface of the carrier 5. The carrier then presents the shape as shown in fig. 4.

Thereupon said carrier 5, the surface of which comprising plastics coated regions 4a to 4d inclusive, can be conveyed towards an etching station 19, where an etching procedure is executed in such a manner that uncoated portions of the carrier 5 are etched away, so that continuous apertures 6 are formed.

Another possibility of the present invention is to treat carrier 5, comprising plastics coated regions 4a to 4d, in a galvanic bath 20 with e.g. a silver ion solution so that silver ions in said galvanic device 20 will be deposited in the regions 9a, 9b and 9c, located between the plastics coated regions 4a to 4d upon the carrier 5.

Thus silver deposits 7a to 7c inclusive are formed in said regions 9a to 9c inclusive.

The installation further comprises a bath 9 in which the secondary plastics pattern of coated regions 4a to 4d is removed from the carrier 5 by a suitable solvent after that the metal products have been subjected to the abovementioned galvanic or chemical treatment. In order to convey said metal products into said bath 9 the installation comprises a guide track 10.

EXAMPLE

A nickel sheet 1 having a thickness of 0,2 mm is provided with a fused photo lacquer coating pattern 2a, 2b, 2c and 2d and is subsequently subjected to a corona discharge. Hereupon said nickel sheet 1 is located below a developing electrode 12, while a liquid toner of epoxy resin particles in an isoparaffin is supplied through an inlet 13, which extends between the developing electrode 12 and the surface of the charged substrate. The developing electrode 12 may for instance have a potential of $^+$25V, whereas the pattern regions 2a to 2d incl. have a potential of $^+$400V.

After having conveyed the carrier and having positioned same below the electrode, the deposited epoxy resin particles are transferred to a copper carrier having a thickness of 0,1 mm, by giving the carrier 5 a potential higher than but of the same polarity as the pattern regions 2a to 2d inclusive. The epoxy resin particles are fused by means of a heating member 18.

A carrier is obtained as shown in fig. 4. If desired, both surfaces of the carrier are provided with a similar plastics pattern.

By an etching procedure (with for instance 1N hydrochloric acid) in etching station 19, the carrier 5 can be provided with continuous apertures 6, said carrier may be used for manufacturing integrating circuits, after having removed the plastics regions 4a to 4d inclusive, in a plastics-removing bath 9 filled with a liquid dissolving the plastics. The finished article is shown in fig. 5A.

The carrier 5 as shown may also be subjected to a galvanic metal deposit with, for instance, gold or silver, in a galvanic

-10-

metal deposit member 20. After having removed the plastics in both 9 by means of, for instance, a ketone, metal products are obtained as shown in fig. 6A, which products may also be used in electric industries. Instead of fusing the plastics particles upon the carriers by a heating treatment, a heated pressure roller, a solvent vapour making the surface of the plastics particles sticky, or a reactive vapour, may be used in such a way that the plastics particles become mutually reticulated. Instead of a liquid toner, such as a dispersion of epoxy resin particles in an isoparaffin, a dry toner consisting of one or two components may also be used.

-1-

CLAIMS

1.    Process of forming a metal article by applying a plastics pattern upon a metal carrier, whether or not followed by a metal removal or metal deposition or chemical treatment known per se and a removal of the plastics, characterized in that a removable plastics pattern coating (4a-4d) is applied upon a charged fixed primary plastics pattern (2a-2d) located upon a conducting substrate (1), said removable plastics being transferred to an electrically conducting carrier (5) by providing a potential difference between the substrate (1) and the carrier (5), thereby forming a secondary plastics pattern (4a-4d) upon the carrier (5), whereupon after having fixed said secondary plastics (4a-4d) pattern, if desired either metal is removed from the carrier (5) by etching or metal (7a-7c) is deposited upon the same and subsequent to said etching or metal deposition or chemical treatment the secondary plastics pattern (4a-4d) is removed.

2.    Process according to claim 1, characterized by one or more of the following measures:

a)    the primary plastics pattern (2a-2d) is charged with a charge having a predetermined polarity in order to have the removable plastics (4a-4d) adhered;

b)    the primary plastics pattern (2a-2d) is provided with a charge having a certain polarity, by means of a corona discharge;

c)    the charged parts of the primary plastics pattern (2a-2d) having a certain polarity, are coated with plastics particles having an opposite polarity;

d)    the plastics particles are applied by means of a dispersion of plastics particles in a non conducting liquid,

-2-

more preferably in an isoparaffin;

e)      the plastics particles are applied in the form of dry particles;

f)      at a constant distance from the charged primary plastics pattern (2a-2d) a surface (12) is maintained possessing an auxiliary electric potential having the same polarity as, but being in an absolute value lower than, the polarity of the primary plastics pattern (2a-2d) while the plastics particles to be deposited upon said charged primary plastics pattern are supplied between the region of the surface (12), comprising the auxiliary electric potential and the charged surface of the primary plastics pattern (2a-2d).

3.      Process according to claim 1 or 2, characterized in that, following the removal of the surface (12) with the auxiliary electric potential, a carrier (5) is provided, which carrier (5) possesses a potential which is in an absolute value, higher than but of the same polarity as the surface potential of the primary plastics pattern (2a-2d), said carrier (5) being maintained at a short distance opposite the coated plastics pattern, whereby the distance between the said two surfaces is constant.

4.      Process according to any one or more of the preceding claims, characterized in that the primary plastics pattern is given a negative charge, whereas the plastics particles to be transferred have been charged positively and/or the removable plastics particles(4a-4d) are applied upon a positive pattern by means of a negatively charged toner, said toner being a liquid toner and/or the removable plastics particles (4a-4d) are applied upon a positive pattern by providing a negatively charged toner, which t ner is a one or 〈 two components powder toner and/or the plastics (4a-4d) upon the carrier (5) is :fixed by heat and/or pressure by solvent vapours and/or by reactive gases and/or both surfaces of the metal carrier (5) are provided with a secondary plastics pattern (4a-4d).

5. Metal article obtained by applying the process as claimed in claims 1 to 4.

6. Installation for applying a plastics coating upon the surface of a metal carrier (5) and by fixing said plastics coating (4a, 4b, 4c, 4d) whether or not followed by a metal removal or metal deposition or chemical treatment known per se, comprising at least a support (16) for a carrier (5), a plastics applying member (14) for applying plastics and a member (18) for fixing the applied plastics, characterized in that the installation at least comprises a member (11) for charging plastics material, a member (14) for applying plastics particles and a member (17) for providing the carrier with a potential.

7. Installation according to claim 6, characterized in that the installation comprises one or more of the following measures:

a) the member (11) for charging the plastics material is a member for exerting a corona discharge;

b) the installation comprises a developing electrode (12) which is connected with a device (21) for providing an auxiliary potential to the developing electrode;

c) the member (14) for applying plastics particles, more particularly for applying electrostatically charged plastics

-4-

particles, extends by means of its mouth (15) between said developing electrode(12) and the support (8) for a substrate (1);

d)     the developing electrode (12) is adjustable in height;

e)     said installation comprises a second support (8) for the support of a substrate (1) to be supplied or having been supplied with a primary plastics pattern (2).

8.     Installation according to claim 6 or 7, characterized in that said installation comprises a metal etching member (19).

9.     Installation according to claims 6 or 7, characterized in that said installation comprises a metal depositing member (20) for galvanically depositing a metal.

10.     Installation according to claims 6 to 9, characterized in that said installation comprises a bath (9) for the removal of the secondary plastics pattern from the treated carrier, which bath (9) is situated beyond the metal etching member (19) or the depositing member (20).

2d  3c  2c  3b  2b  3a  2a

*Fig:1.*

4d  4c  4b  4a

2d  2c  2b  2a

*Fig:2.*

4d  8c  4c  8b  4b  8a  4a

5

2d  3c  2c  3b  2b  3a  2a

*Fig:3.*

4d  9c  4c  9b  4b  9  4a

5

*Fig:4.*

4  6  4c  6  4b  6  4a

5

*Fig:5.*

4d  7c  4c  7b  4b  7a  4a

5

*Fig:6.*

6  6  6

5

*Fig:5a.*

7c  7b  7a

5

*Fig:6a.*

**FIG. 7**

0041292

European Patent
Office

**EUROPEAN SEARCH REPORT**

**0041292**

Application number

EP 81 20 0542

## DOCUMENTS CONSIDERED TO BE RELEVANT

| Category | Citation of document with indication, where appropriate, of relevant passages | Relevant to claim |
|---|---|---|
| A | FR - A - 2 227 952 (KALLE A.G.)<br>* Pages 1,2 * | 1,6 |
| | -- | |
| A | FR - A - 1 480 896 (RANK XEROX LTD.)<br>* Page 2, column 1, lines 10-40 * | 1,6 |
| | -- | |
| A | GB - A - 1 204 246 (RANK XEROX LTD.)<br>* Claim 8 * | 1,6 |
| | -- | |
| A | US - A - 3 999 481 (J.G. SANKUS JR.)<br>* Column 2, line 38; column 3, line 37 * | 1,6 |
| | ---- | |

**CLASSIFICATION OF THE APPLICATION (Int. Cl.³)**

G 03 C 5/00
G 03 G 13/26
B 41 C 1/10

**TECHNICAL FIELDS SEARCHED (Int. Cl.³)**

B 41 C 1/10
1/14
G 03 C 5/00
G 03 G 5/02
13/22
13/26
13/28
13/32

**CATEGORY OF CITED DOCUMENTS**

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

The present search report has been drawn up for all claims

| Place of search | Date of completion of the search | Examiner |
|---|---|---|
| The Hague | 14-08-1981 | BOEYKENS |

EPO Form 1503.1 06.78